(19) **Europäisches Patentamt**

**European Patent Office**

**Office européen des brevets**

(11) **EP 1 336 208 B1**

(12) **EUROPÄISCHE PATENTSCHRIFT**

(45) Veröffentlichungstag und Bekanntmachung des Hinweises auf die Patenterteilung:
**04.10.2006 Patentblatt 2006/40**

(21) Anmeldenummer: **01996894.0**

(22) Anmeldetag: **20.11.2001**

(51) Int Cl.:
**H01L 51/50** $^{(2006.01)}$

(86) Internationale Anmeldenummer:
**PCT/DE2001/004422**

(87) Internationale Veröffentlichungsnummer:
**WO 2002/041414 (23.05.2002 Gazette 2002/21)**

(54) **LICHTEMITTIERENDES BAUELEMENT MIT ORGANISCHEN SCHICHTEN**

LIGHT EMITTING COMPONENT COMPRISING ORGANIC LAYERS

COMPOSANT LUMINESCENT COMPORTANT DES COUCHES ORGANIQUES

(84) Benannte Vertragsstaaten:
**AT BE CH CY DE DK ES FI FR GB GR IE IT LI LU MC NL PT SE TR**

(30) Priorität: **20.11.2000 DE 10058578**

(43) Veröffentlichungstag der Anmeldung:
**20.08.2003 Patentblatt 2003/34**

(73) Patentinhaber: **Novaled AG**
**01307 Dresden (DE)**

(72) Erfinder:
• **PFEIFFER, Martin**
**01139 Dresden (DE)**
• **LEO, Karl**
**01219 Dresden (DE)**
• **BLOCHWITZ-NIEMOTH, Jan**
**01099 Dresden (DE)**
• **ZHOU, Xiang Prof. Dr.**
**135 XinGang XiLu, 510275 Guangzhou (CN)**

(74) Vertreter: **Bittner, Thomas L. et al**
**Forrester & Boehmert**
**Pettenkoferstrasse 20-22**
**80336 München (DE)**

(56) Entgegenhaltungen:
**EP-A- 1 017 118          US-A- 5 093 698**

• **YAMAMORI A ET AL: "DOPED ORGANIC LIGHT EMITTING DIODES HAVING A 650-NM-THICK HOLE TRANSPORT LAYER" APPLIED PHYSICS LETTERS, AMERICAN INSTITUTE OF PHYSICS. NEW YORK, US, Bd. 72, Nr. 17, 27. April 1998 (1998-04-27), Seiten 2147-2149, XP000754421 ISSN: 0003-6951**

• **BLOCHWITZ J ET AL: "LOW VOLTAGE ORGANIC LIGHT EMITTING DIODES FEATURING DOPED PHTHALOCYANINE AS HOLE TRANSPORT MATERIAL" APPLIED PHYSICS LETTERS, AMERICAN INSTITUTE OF PHYSICS. NEW YORK, US, Bd. 73, Nr. 6, 10. August 1998 (1998-08-10), Seiten 729-731, XP000774933 ISSN: 0003-6951**

• **NODA T ET AL: "A BLUE-EMITTING ORGANIC ELECTROLUMINESCENT DEVICE USING A NOVEL EMITTING AMORPHOUS MOLECULAR MATERIAL, 5,5'-BIS(DIMESITYLBORYL)-2,2'-BITHIOPHENE" ADVANCED MATERIALS, VCH VERLAGSGESELLSCHAFT, WEINHEIM, DE, Bd. 11, Nr. 4, 4. März 1999 (1999-03-04), Seiten 283-285, XP000802711 ISSN: 0935-9648 in der Anmeldung erwähnt**

• **HUNG L S ET AL: "ENHANCED ELECTRON INJECTION IN ORGANIC ELECTROLUMINESCENCE DEVICES USING AN AI/LIF ELECTRODE" APPLIED PHYSICS LETTERS, AMERICAN INSTITUTE OF PHYSICS. NEW YORK, US, Bd. 70, Nr. 2, 13. Januar 1997 (1997-01-13), Seiten 152-154, XP000680570 ISSN: 0003-6951**

• **PFEIFFER ET AL.: "Controlled n type doping of a molecular organic semiconductor: Naphtalenetetracarboxylic dianhydride (NTCDA) doped with bis(ethylenedithio)-tetrathiafulvalene (BEDT-TTF)" JOURNAL OF APPLIED PHYSICS, Bd. 87, Nr. 9, 1. Mai 2000 (2000-05-01), Seiten 4340-4343,**

EP 1 336 208 B1

**Beschreibung**

Die Erfindung betrifft ein lichtemittierendes Bauelement mit einer Anordnung organischer Schichten.

Hintergrund der Erfindung

Organische Leuchtdioden sind seit der Demonstration niedriger Betriebsspannungen von Tang et al. 1987 [C.W. Tang et al. Appl. Phys. Lett. 51 (12), 913 (1987)] aussichtsreiche Kandidaten für die Realisierung großflächiger Displays. Sie bestehen aus einer Reihenfolge dünner (typischerweise 1 nm bis 1 $\mu$m) Schichten aus organischen Materialien, welche bevorzugt im Vakuum aufgedampft oder in ihrer polymeren Form aufgeschleudert werden. Nach elektrischer Kontaktierung durch Metallschichten bilden sie vielfältige elektronische oder optoelektronische Bauelemente, wie z. B. Dioden, Leuchtdioden, Photodioden und Transistoren, die mit ihren Eigenschaften den etablierten Bauelementen auf der Basis anorganischer Schichten Konkurrenz machen.

Im Falle der organischen Leuchtdioden (OLEDs) wird durch die Injektion von Ladungsträgern (Elektronen von der einen, Löcher von der anderen Seite) aus den Kontakten in die anschließenden organischen Schichten infolge einer äußeren angelegten Spannung, der folgenden Bildung von Exzitonen (Elektron-Loch-Paaren) in einer aktiven Zone und der strahlenden Rekombination dieser Exzitonen, Licht erzeugt und von der Leuchtdiode emittiert.

Der Vorteil solcher Bauelemente auf organischer Basis gegenüber den konventionellen Bauelementen auf anorganischer Basis (Halbleiter wie Silizium, Galliumarsenid) besteht darin, dass es möglich ist, sehr großflächige Elemente herzustellen, also große Anzeigeelemente (Bildschirme, Screens). Die organischen Ausgangsmaterialien sind gegenüber den anorganischen Materialien relativ billig (geringer Material- und Energieaufwand). Obendrein können diese Materialien aufgrund ihrer gegenüber anorganischen Materialien geringen Prozeßtemperatur auf flexible Substrate aufgebracht werden, was eine ganze Reihe von neuartigen Anwendungen in der Display- und Beleuchtungstechnik eröffnet.

Der prinzipielle Aufbau eines solchen Bauelementes stellt eine Anordnung aus einer oder mehrerer der folgenden Schichten dar:

1. Träger, Substrat,
2. Basiselektrode, löcherinjizierend (Pluspol), meist transparent,
3. Löcher injizierende Schicht,
4. Löcher transportierende Schicht (HTL),
5. Lichtemittierende Schicht (EL),
6. Elektronen transportierende Schicht (ETL),
7. Elektronen injizierende Schicht,
8. Deckelektrode, meist ein Metall mit niedriger Austrittsarbeit, elektroneninjizierend (Minuspol),
9. Kapselung, zum Ausschluß von Umwelteinflüssen.

Dies ist der allgemeinste Fall, meistens werden einige Schichten weggelassen (außer 2., 5. und 8.), oder aber eine Schicht kombiniert in sich mehrere Eigenschaften.

Aus US 5,093,698 ist es bekannt, die löcherleitende und/oder die elektronenleitende Schicht mit anderen organischen Molekülen zu dotieren, um deren Leitfähigkeit zu erhöhen. Die weitere Forschung hat aber diesen Ansatz nicht mehr verfolgt.

Weitere bekannte Ansätze zur Verbesserung der elektrischen Eigenschaften von OLEDs (also vor allem Betriebsspannung und Lichtemissionseffizienz) sind:

1) die lichtemittierende Schicht zu verbessern (neuartige Materialien) [US 5,674,635],

2) die lichtemittierende Schicht aus einem Matrixmaterial und einem Dotanden aufzubauen, wobei ein Energieübertrag von der Matrix zum Dotand stattfindet und die strahlende Rekombination der Exzitonen allein auf dem Dotanden stattfindet [US 4,769,292, US 5,409,783, H. Vestweber, W. Rieß: "Highly efficient and stable organic light-emittingdiodes", in "Synthetic Metal" 91 (1997), 181-185],

3) Polymere (aufschleuderbar) oder niedrigmolekulare (aufdampfbar) Stoffe, welche mehrere günstige Eigenschaften (Leitfähigkeit, Schichtbildung) in sich vereinen, bzw. diese aus Mischung von verschiedenen Materialien herzustellen (vor allem im Falle der polymeren Schichten) [US 5,281,489],

4) die Injektion von Ladungsträgern in die organischen Schichten zu verbessern, indem mehrere Schichten mit stufenweiser Abstimmung ihrer Energielagen verwendet werden, oder entsprechende Mischungen aus mehreren Substanzen verwendet werden [US 5,674,597, US 5,601,903, US 5,247,226, Tominaga et al. Appl. Phys. Lett. 70 (6), 762 (1997), US 5,674,597],

5) die Transporteigenschaften der Transportschichten zu verbessern, indem der Transportschicht eine besser geeignetes Material beigemischt wird. Dabei findet der Transport z. B. in der Löcherschicht auf den Dotanden / der Beimischung statt (im Unterschied zur oben erwähnten Dotierung, bei der der Transport der Ladungsträger auf den Molekülen des Matrixmaterials stattfindet [EP 961 330 A2].

Im Unterschied zu Leuchtdioden auf Basis anorganischer Materialien, die in der Praxis schon seit langer Zeit breite Anwendung finden, müssen die organischen Bauelemente bisher bei erheblich höheren Spannungen betrieben werden. Die Ursache dafür liegt in der schlechten Injektion von Ladungsträgern aus den Kontakten in die organischen Schichten und in der vergleichsweise schlechten Leitfähigkeit und Beweglichkeit der Ladungsträgertransportschichten. An der Grenzfläche Kontaktmaterial / Ladungsträgertransportschicht bildet sich eine Potentialbarriere aus, welche für eine erhebliche Erhöhung der Betriebsspannung sorgt. Abhilfe könnte die Verwendung von Kontaktmaterialien mit höherem Energieniveau (= geringere Austrittsarbeit) zur Injektion von Elektronen in die angrenzende organische Schicht, so wie es in US 5,093,698 schematisch dargestellt ist, oder Kontaktmaterialien mit noch niedrigeren Energieniveaus (höheren Austrittsarbeiten) zur Injektion von Löchern in eine angrenzende organische Schicht, schaffen. Im ersten Fall spricht die extreme Instabilität und Reaktivität der entsprechenden Metalle dagegen, im zweiten Fall die geringe Transparenz dieser Kontaktmaterialien. In Praxi wird daher zur Zeit fast ausschließlich Indium-Zinn-Oxid (ITO) als Injektionskontakt für Löcher eingesetzt (ein transparenter entarteter Halbleiter), dessen Austrittsarbeit aber immer noch zu gering ist. Für die Elektroneninjektion kommen Materialien wie Aluminium (Al), Al in Kombination mit einer dünnen Schicht Lithiumfluorid (LiF), Magnesium (Mg), Kalzium (Ca) oder eine Mischschicht aus Mg und Silber (Ag) zum Einsatz.

In US 5,093,698 ist die Verwendung von dotierten Ladungsträgertransportschichten (p-Dotierung der HTL durch Beimischung von akzeptorartigen Molekülen, n-Dotierung der ETL durch Beimischung von donatorartigen Molekülen) beschrieben. Unter Dotierung in diesem Sinne ist gemeint, dass durch die Beimischung der Dotiersubstanzen in die Schicht die Gleichgewichtsladungsträgerkonzentration in dieser Schicht erhöht wird, verglichen mit den reinen Schichten aus einer der zwei beteiligten Substanzen, was sich in einer verbesserten Leitfähigkeit und besseren Ladungsträgerinjektion aus den angrenzenden Kontaktschichten in diese Mischschicht äußert. Der Transport der Ladungsträger findet dann immer noch auf den Matrixmolekülen statt.

Nach US 5,093,698 werden die dotierten Schichten als Injektionsschichten an der Grenzfläche zu den Kontaktmaterialien verwendet, dazwischen (oder bei der Verwendung nur einer dotierten Schicht, nächstens zum anderen Kontakt) befindet sich die lichtemittierende Schicht. Aufgrund der durch Dotierung erhöhten Gleichgewichtsladungsträgerdichte und der damit verbundenen Bandverbiegung wird die Ladungsträgerinjektion erleichtert. Die Energielagen der organischen Schichten (HOMO-highest occupied molecular orbital oder hochenergetischste Valenzbandenergie, LUMO-lowest unoccupied molecular orbital oder niederenergetischste Leitungsbandenergie) sollen nach US 5,093,698 so beschaffen sein, daß sowohl Elektronen aus der ETL als auch Löcher aus der HTL ohne weitere Barriere in die EL injiziert werden können, was eine sehr hohe Ionisationsenergie des HTL-Materials und eine sehr geringe Elektronenaffinität des ETL-Materials erfordert. Derartige Materialien sind aber nur schwer dotierbar, da extrem starke Akzeptoren bzw. Donatoren benötigt würden, so dass diese Bedingungen mit in der Realität zur Verfügung stehenden Materialien nicht auf beiden Seiten vollständig erfüllt werden können. Verwendet man nun HTL- bzw. ETL-Materialien, die diese Bedingung nicht erfüllen, kommt es bei angelegter Spannung zu einer Akkumulation von Ladungsträgern in den Transportschichten an den Grenzflächen zur emittierenden Schicht (EL). Eine derartige Akkumulation begünstigt prinzipiell die nichtstrahlende Rekombination der Exzitonen an der Grenzfläche, z. B. durch die Bildung von Exciplexen (diese bestehen aus einem Ladungsträger in der HTL bzw. ETL und dem entgegengesetzten Ladungsträger in der EL). Solche Exciplexe rekombinieren überwiegend nicht-strahlend, so dass die Exciplexbildung einen nichtstrahlenden Rekombinationsmechanismus darstellt. Das Problem der Exciplexbildung verschärft sich zusätzlich, wenn man dotierte HTLs bzw. ETLs verwendet, da in dotierten Materialien die Debysche Abschirmlänge sehr gering ist und damit sehr hohe Ladungsträgerdichten direkt an der Grenzfläche auftreten. Außerdem können Dotanden in unmittelbarer Nachbarschaft der EL zu einer Löschung der Fluoreszenz z. B. durch Förstertransfer führen.

Blockschichten in OLEDs zur Verbesserung der Ladungsträgerbalance in der jeweiligen lichtemittierenden Schicht sind aus der Literatur bekannt. Deren Funktion besteht darin, Ladungsträger am Verlassen der lichtemittierenden Schicht zu hindern. Im Falle der Elektronen in der Emitterschicht ist also die Bedingung, dass das LUMO der Elektronenblockschicht (welche sich zwischen der Emitter- und der Löchertransportschicht befindet) deutlich über dem LUMO der Emitterschicht liegt und die Blockschicht so dick ausgeführt sein muß, dass kein Tunneln von Elektronen in die darauffolgende Löchertransportschicht mehr stattfinden kann. Für die Löcher aus der Emitterschicht gilt die selbe Argumentation mit den Energien der HOMOs. Beispiele hierfür sind zu finden in: M.-J. Yang and T. Tsutsui: "Use of Poly (9-vinylcarbazole) as host material of Iridium complexes in high-efficiency organic light-emitting devices" in Jpn. J. Appl. Phys. 39 (2000), Part2, No. 8A, S. L828-L829; R.S. Deshpande et al. "White-light-emitting organic electroluminescent devices based on interlayer sequential energy transfer" in Appl. Phys. Lett. 75 (1999) 7, S. 888-890; M. Hamaguchi and K. Yoshino: "Color-variable emission in multilayer polymer electroluminescent devices containing electron-blocking layer" in Jpn. J. Appl. Phys. 35 (1996), Part1, No. 9A, S. 4813-4818. Für die Herstellung von speziell blauen OLEDs ist die Auswahl passender Blockschichten und damit die Einschränkung der möglichen Emissionszonen von besonderer Bedeutung.

Hinweise auf Exciplexbildung zwischen organischen Emittermaterialien und undotierten Transportmaterialien mit niedriger Ionisationsenergie finden sich in: K. Itano et al.: "Exciplex formation at the organic solid-stat interface: yellow emission in organic light-emitting diodes using green-fluorescent tris(8-Quinolinolato)aluminium and hole-transporting molecular materials with low ionization potentials" in Appl. Phys. Lett. 72 (1998) 6, S. 636-638; T. Noda et al. "A blue-emitting organic electroluminescent device using a novel emitting amorphous molecular material, 5,5 '-bis(Dimesitylboryl)-2,2 '-bithiophene" in "Adv. Mater." 11 (1999) 4, pp. 283-285. In letzterem wird der Einsatz einer Blockschicht zur Verminderung dieses Effektes vorgestellt, allerdings nicht in Zusammenhang mit dotierten Transportschichten. Das prinzipielle Dilemma, daß Materialien mit tief liegendem HOMO schwer p-dotierbar sind, Materialien mit hoch liegendem HOMO aber an der Grenzfläche zur emittierenden Schicht Exciplexbildung begünstigen, wurde von der Fachliteratur bisher nicht erkannt. Dementsprechend finden sich auch keine Patente, die Lösungen für dieses Problem vorschlagen.

Aus dem Dokument EP 1 017 118 A ist ein lichtemittierendes Bauelement mit organischen Schichten, insbesondere organische Leuchtdiode, mit wenigstens einer dotierten Ladungsträgertransportschicht, einer lichtemittierenden Schicht und Kontaktschichten bekannt, bei dem zwischen der Ladungsträgertransportschicht und der lichtemittierenden Schicht eine Blockschicht aus einem organischen Material vorgesehen ist. Zwischen einer Elektronentransportschicht und einer Kathode aus Aluminium ist eine LiF-Schicht angeordnet. Zwischen einer Anode und einer Löchertransportschicht ist eine Schicht aus CuPc vorgesehen.

Aus Blochwitz et al. ("Low voltage organic light emitting diodes featuring doped phthalocyanine as hole transport material", Appl. Phys. Lett., American Institute of Physics, New York, US, Bd. 73, Nr. 6, 10. August 1998, Seiten 729-731) ist ein lichtemittierendes Bauelement mit einer Anordnung organischer Schichten mit einer löcherinjizierenden Anode aus ITO, einer elektroneninjizierenden Kathode aus Aluminium und einer lichtemittierenden Schicht aus Alq3 bekannt, welche ein höchstes besetztes Energieniveau von -5,65eV und ein niedrigstes unbesetztes Energieniveau von -2,9eV aufweist. Weiterhin sind eine Löchertransportschicht aus VOPc und eine löcherseitige Blockschicht aus TPD vorgesehen, welche ein höchstes besetztes Energieniveau von -5,4eV und ein niedrigstes unbesetztes Energieniveau von -2,3eV aufweist, wobei die Löchertransportschicht eine organische Hauptsubstanz (VOPc) und eine akzeptorartige Dotierungssubstanz (F4-TCNQ) aufweist. Es gelten die folgenden Beziehungen für die Energieniveaus:

$$E_{vblockp}-E_{vel}<0,3eV \ (0,25eV \ Differenz)$$
$$E_{cblockp}>E_{cel}, \ (-2,3 > -2,9) \ und$$
$$E_{vp} \ (-5,3)>E_{vblockp} \ (-5,4), \ wenn \ E_{vp} \ (-5,3)>E_{vel} \ (-5,65),$$

wobei $E_{vp}$ (-5,3eV) ein höchstes besetztes Energieniveau der Löchertransportschicht bezeichnet.

Zusammenfassung der Erfindung

Die Aufgabe der Erfindung besteht darin, ein lichtemittierendes Bauelement auf Basis dotierter Ladungsträgertransportschichten anzugeben, das mit einer verringerten Betriebsspannung betrieben werden kann und eine erhöhte Lichtemissionseffizienz aufweist.

Diese Aufgabe wird erfindungsgemäß durch ein lichtemittierendes Bauelement nach dem unabhängigen Anspruch 1 gelöst. Vorteilhafte Ausgestaltungen der Erfindung sind Gegenstand von abhängigen Unteransprüchen.

Dabei sollen die Abweichungen von den genannten Werten immer einige kT bei Betriebstemperatur des Bauelementes entsprechend können (mit einige kT ist bis zu 5kT gemeint, also ca. 5*25meV bei Raumtemperatur).

Die Ladungsträgertransportschicht ist durch eine Beimischung einer organischen oder anorganischen Substanz (Dotand) dotiert. Die energetische Lage des Majoritätsladungsträgertransportzustandes wird dabei so gewählt, dass bei dem gegebenen Dotanden eine effiziente Dotierung möglich ist (möglichst vollständiger Ladungsübertrag von Matrix auf Dotanden).

Die Blockschicht befindet sich erfindungsgemäß zwischen der Ladungsträgertransportschicht und einer lichtemittierenden Schicht des Bauelementes, in welcher die Umwandlung der elektrischen Energie der durch Stromfluß durch das Bauelement injizierten Ladungsträger in Licht stattfindet. Die Substanzen der Blockschichten werden erfindungsgemäß so gewählt, daß bei angelegter Spannung (in Richtung der Betriebsspannung) aufgrund ihrer Energieniveaus keine Akkumulation von Majoritätsladungsträger (HTL-Seite: Löcher, ETL-Seite: Elektronen) in der Blockschicht an der Grenzfläche zur emittierenden Schicht auftritt. Um diese Bedingung gleichzeitig mit der Forderung nach effizienter Dotierbarkeit zu realisieren, wird eine energetische Barriere für die Injektion von Ladungsträgern aus der Transportschicht in die Blockschicht in Kauf genommen.

Dieser Ansatz unterscheidet sich insofern deutlich von dem in EP 1 017 118 A2 dargestellten:

Keine der in diesem Patent aufgelisteten Ausführungsbeispiele erfüllt obige Bedingungen. Dementsprechend sind auch die dort erwähnten Leuchtdioden sowohl im Bezug auf die Betriebsspannung als auch auf die Effizienz deutlich schlechter als die von uns angegebenen Ausführungsbeispiele. Die in EP 1 017 118 A2 vorgeschlagene Blockschicht dient nur zur Verhinderung der Injektion von Minoritätsladungsträgern. Diese Funktion kann von der hier vorgeschlagenen Blockschicht auch erfüllt werden, sie sollte also zusätzlich die Bedingung erfüllen, daß die Minoritätsladungsträger effizient an der Grenzschicht lichtemittierende Schicht/Blockschicht aufgehalten werden. In einer vorzugsweisen Ausführung des Bauelementes genügen die Energieniveaus der Blockschichten und der Emitterschicht daher folgenden Bedingungen:

a) Bedingung für löcherseitige Blockschicht (3) und emittierende Schicht (4): $E_{Cblockp} > E_{Cel}$ (LUMO Energie der löcherseitigen Blockschicht > LUMO Energie der lichtemittierenden Schicht),
b) Bedingung für elektronenseitige Blockschicht (3') und emittierende Schicht (4): $E_{Vblockn} < E_{Vel}$ (HOMO Energie der elektronenseitigen Blockschicht < HOMO Energie der lichtemittierenden Schicht).

Weiterhin vorteilhaft für ein Bauelement ist es, daß die Bandlücke der dotierten Transportschichten so groß gewählt ist, daß eine Injektion von Minoritätsladungsträgern aus der emittierenden Schicht in die dotierte Transportschicht selbst dann nicht möglich ist, wenn die Blockschicht so dünn ist, daß sie durchtunnelt werden kann. Dies wird erfindungsgemäß dadurch realisiert daß folgende Bedingungen erfüllt sind:

a) Bedingung für p-dotierte Löchertransportschicht (2) und emittierende Schicht (4): $E_{Cp} > E_{Cel}$ (LUMO der Injektions- und Transportschicht für Löcher > LUMO Energie der lichtemittierenden Schicht),
b) Bedingung für elektronenseitige Blockschicht (2') und emittierende Schicht (4): $E_{Vn} < E_{Vel}$ (HOMO Energie der Injektions- und Transportschicht für Elektronen < HOMO Energie der lichtemittierenden Schicht).

Eine vorteilhafte Ausführung einer Struktur einer erfindungsgemäßen OLED beinhaltet folgende Schichten:

1. Träger, Substrat,
2. Basiselektrode, löcherinjizierend (Anode = Pluspol), vorzugsweise transparent,
3. p-dotierte Löcher injizierende und transportierende Schicht,
4. löcherseitige Blockschicht (typischerweise dünner als p-dotierte Schicht aus Pkt. 3) aus einem Material, dessen Bandlagen zu den Bandlagen der sie umgebenden Schichten paßt,
5. lichtemittierende Schicht,
6. dünnere elektronenseitige Blockschicht aus einem Material dessen Bandlagen zu den Bandlagen der sie umgebenden Schichten paßt,
7. hoch n-dotierte Elektronen injizierende und transportierende Schicht,
8. Deckelektrode, meist ein Metall mit niedriger Austrittsarbeit, elektroneninjizierend (Kathode = Minuspol),
9. Kapselung, zum Ausschluß von Umwelteinflüssen.

Die Substanzen der Blockschichten werden erfindungsgemäß so gewählt, dass sie bei angelegter Spannung (in Richtung der Betriebsspannung) aufgrund ihrer Energieniveaus effizient Ladungsträger in die lichtemittierende Schicht (EL) injizieren können und an der Grenzfläche zur EL nichtstrahlende Rekombinationsprozesse wie Exciplexbildung unwahrscheinlich sind, Ladungsträger aus der EL aber nicht in die genannte zweite Schicht injiziert werden können. Das bedeutet, daß die Substanzen der Blockschichten erfindungsgemäß so gewählt werden, daß sie bei angelegter Spannung (in Richtung der Betriebsspannung) aufgrund ihrer Energieniveaus die Majoritätsladungsträger (löcherseitig: Löcher, elektronenseitig: Elektronen) überwiegend an der Grenzschicht dotierte Ladungsträgertransportschicht/Blockschicht aufhalten, aber die Minoritätsladungsträger effizient an der Grenzschicht lichtemittierende Schicht / Blockschicht aufhalten.

Es ist auch im Sinne der Erfindung, wenn nur eine Blockschicht Verwendung findet, weil die Bandlagen der injizierenden und transportierenden Schicht und der Lichtemissionsschicht bereits auf einer Seite zueinander passen. Auch kann unter Umständen nur eine Seite (löcher- oder elektronenleitende) dotiert sein. Des weiteren können die Funktionen der Ladungsträgerinjektion und des Ladungsträgertransports in den Schichten 3 und 7 auf mehrere Schichten aufgeteilt sein, von denen mindestens eine dotiert ist. Die molaren Dotierungskonzentrationen liegen typischerweise im Bereich von 1:10 bis 1:10000. Falls die Dotanden wesentlich kleiner sind als die Matrixmoleküle, können in Ausnahmefällen auch mehr Dotanden als Matrixmoleküle in der Schicht sein (bis 5:1). Die Dotanden können organisch oder anorganisch sein. Typische Schichtdicken für die Blockschichten liegen im Bereich 1 nm bis 20 nm, können unter Umständen aber auch dicker sein. Typischerweise sind die Blockschichten dünner als ihre entsprechenden angrenzenden dotierten Schichten. Die Schichtdicken der Blockschichten müssen groß genug sein, um Exciplexbildung zwischen den geladenen Molekülen der Substanzen in den entsprechend angrenzenden Mischschichten und den geladenen Molekülen der elektrolumineszierenden Schicht und Lumineszenzlöschung durch die Dotanden selbst zu verhindern.

Zusammenfassend läßt sich die erfindungsgemäße Leistung wie folgt beschreiben: Um ein organisches Transportmaterial (hier nur erläutert für die Löcherseite, die Elektronenseite folgt analog mit Austausch der Begriffe HOMO und LUMO) effizient p-dotieren zu können, muss dessen Ionisationspotential relativ klein sein, wodurch sich ein großer HOMO- Abstand zwischen der Transportschicht und der Emitterschicht ergibt. Eine Folge der effizienten Dotierung ist, daß alle Dotanden vollständig ionisiert in der Schicht vorliegen (im Falle der p-Dotierung sind die Dotanden, die Akzeptoren, alle negativ geladen). Daher ist keine Elektroneninjektion aus der Emitterschicht zu den Dotanden der Transportschicht mehr möglich. Auf diesen bei effizienter Dotierung nicht mehr existenten Nachteil, nämlich ungeladene Dotanden in der Transportschicht, wird in EP 1 017 118 A2 eingegangen. Dort wird er durch Blockschichten zur Verhinderung der Injektion von Elektronen aus der Emitterschicht in die Löchertransportschicht gelöst.

Im Gegensatz dazu kann in der hier vorgeschlagenen Lösung die Blockschicht extrem dünn gewählt werden, da sie hauptsächlich Exciplexbildung verhindern soll, aber keine Tunnelbarriere für Ladungsträger darstellen muss (im Unterschied zu EP 1 017 118 A2).

Beschreibung von bevorzugten Ausführungsbeispiele der Erfindung

Die Erfindung wird nachfolgend anhand von bevorzugten Ausführungsbeispielen unter Bezugnahme auf Figuren einer Zeichnung näher erläutert. Hierbei zeigen:

Fig. 1 eine theoretisch ideale dotierte OLED Struktur,
Fig. 2 eine in der Praxis vorhandene dotierte OLED ohne Blockschicht,
Fig. 3 eine dotierte OLED mit Blockschichten, und
Fig. 4 eine nur auf der Löcherseite dotierte OLED mit dortiger Blockschicht.

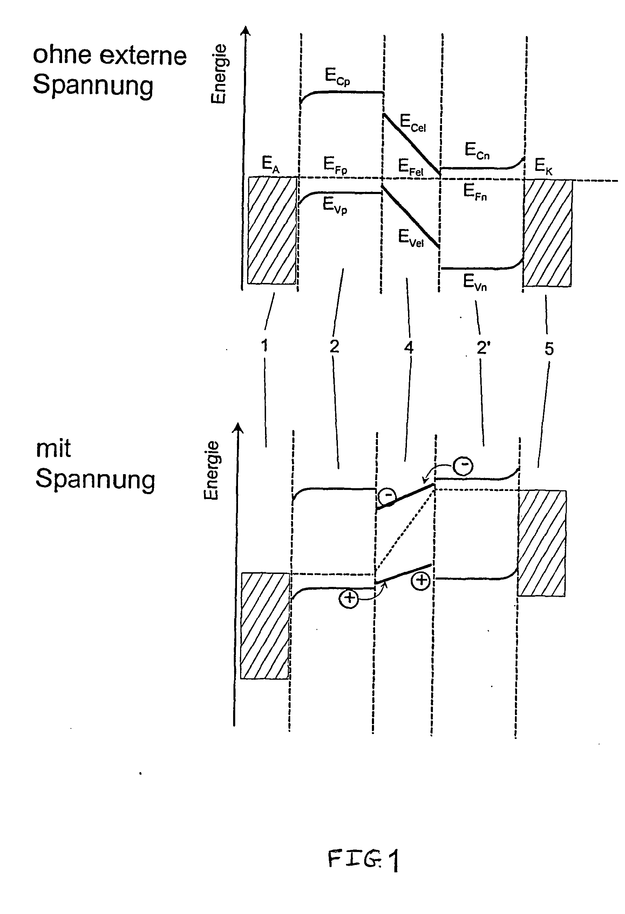

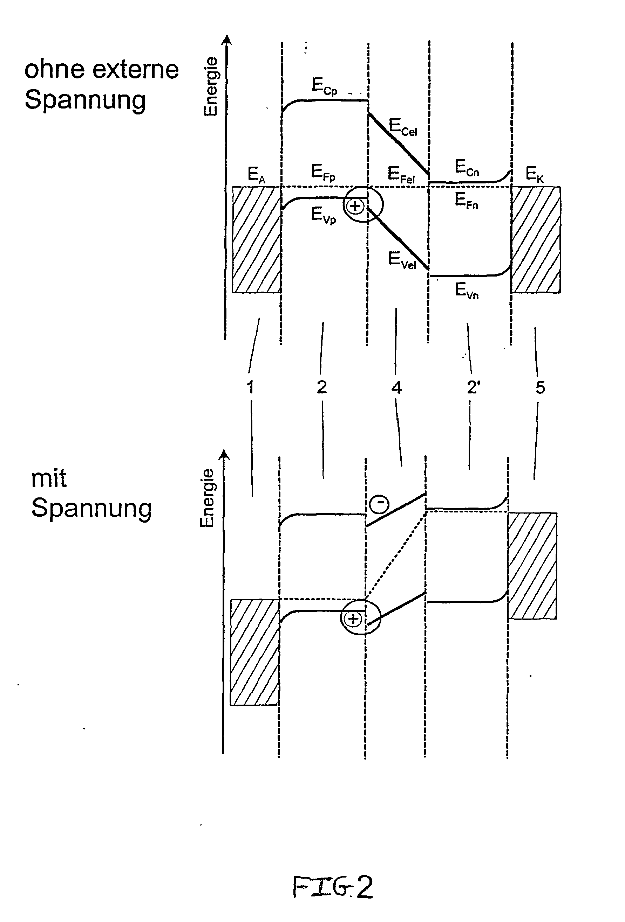

In Fig. 1 ist eine theoretisch ideale Struktur dargestellt, bestehend aus einer Anode ($E_A$), einer hoch p-dotierten Löcherinjektions- und Transportschicht ($E_{Vp}$, $E_{Cp}$, $E_{Fp}$), einer elektrolumineszierenden Schicht ($E_{Vel}$, $E_{Cel}$, $E_{Fel}$), einer hoch n-dotierten elektroneninjizierenden und transportierende Schicht ($E_{Vn}$, $E_{Cn}$, $E_{Fn}$) und einer Kathode. Mit angelegter Spannung (Anode positiv gepolt) werden Löcher aus der Anode und Elektronen aus der Kathode in Richtung lichtemittierende Schicht injiziert. Da für Löcher an der Grenzfläche p-dotierter Schicht zur lichtemittierenden Schicht keine Barriere auftritt ($E_{Vp} < E_{Vel}$), und für Elektronen an der Grenzfläche n-dotierter Schicht zur lichtemittierenden Schicht ebenfalls nicht ($E_{Cn} > E_{Cel}$), sowie an den Grenzflächen lichtemittierende Schicht zur p-dotierten bzw. n-dotierten. Schicht für Elektronen resp. Löcher eine hohe Barriere besteht ($E_{Cel} < E_{Cp}$ bzw. $E_{Vel} > E_{Vn}$), sammeln sich die Ladungsträger (Elektronen und Löcher) in der lichtemittierenden Schicht, wo sie effizient Exzitonen bilden und strahlend rekombinieren können. In der Realität sind Schichtkombinationen mit den oben genannten Parametern bis heute nicht zu finden und werden vielleicht nie gefunden werden, da diese Schichten eine Vielzahl von teilweise widerstrebenden Eigenschaften in sich vereinigen müssen. Eine realisierbare Schichtstruktur sieht wie in Fig. 2 (schematische Bandlagen) angegeben aus.

Der bisher beste bekannte organische Akzeptor zur p-Dotierung organischer Materialien (Tetra-fluoro-tetra-cyano-chinodimethan $F_4$-TCNQ) kann aufgrund seiner Bandlage $E_{Cpdot}$ Materialien mit einer Valenzbandlage von ca. $E_{Vp}$ = -5.0 bis -5.3eV effizient dotieren. Das meistverwendete Material zur Erzeugung von Elektrolumineszenz, Aluminium-tris-quinolinate ($Alq_3$) hat eine Valenzbandlage von $E_{Vel}$ = -5.65eV. Somit werden die in der p-dotierten Schicht geleiteten Löcher an der Grenzfläche zur elektrolumineszierenden Schicht geblockt ($E_{vp} > E_{Vel}$). Das gleiche gilt für die Grenzfläche zwischen n-dotierter und lichtemittierender Schicht ($E_{Cn} < E_{Cel}$), da das Leitungsband eines grünen oder blauen Emittermaterials sehr weit vom Valenzband entfernt ist (große Bandlücke $E_{Cel}$ - $E_{Vel}$). Um aber überhaupt noch eine gute Konversionseffizienz zu erreichen, müssen die Bandlagen am Übergang lichtemittierender Schicht zur p-leitenden Schicht für Elektronen und lichtemittierender Schicht zur n-leitenden Schicht für Löcher noch so beschaffen sein, daß Elektronen bzw. Löcher auch dort effizient geblockt werden ($E_{Cel} < E_{Cp}$ bzw. $E_{Vel} > E_{Vn}$), wie zuvor für den theoretisch idealen Fall beschrieben. Damit ergibt es sich aber, daß sich bei angelegter Spannung an den Grenzflächen der dotierten Schichten zur lichtemittierenden Schicht Ladungsträger akkumulieren. Bei Akkumulation entgegengesetzter Ladung auf beiden Seiten einer Grenzfläche treten vermehrt nichtstrahlende Rekombinationsprozesse auf, z. B. durch Bildung von Exciplexen, was wiederum die Konversionseffizienz von elektrischer in optische Energie verringert. Mit einer LED mit dieser Schichtstruktur kann man also durch Dotierung die Betriebsspannung verringern, aber nur auf Kosten der Effizienz.

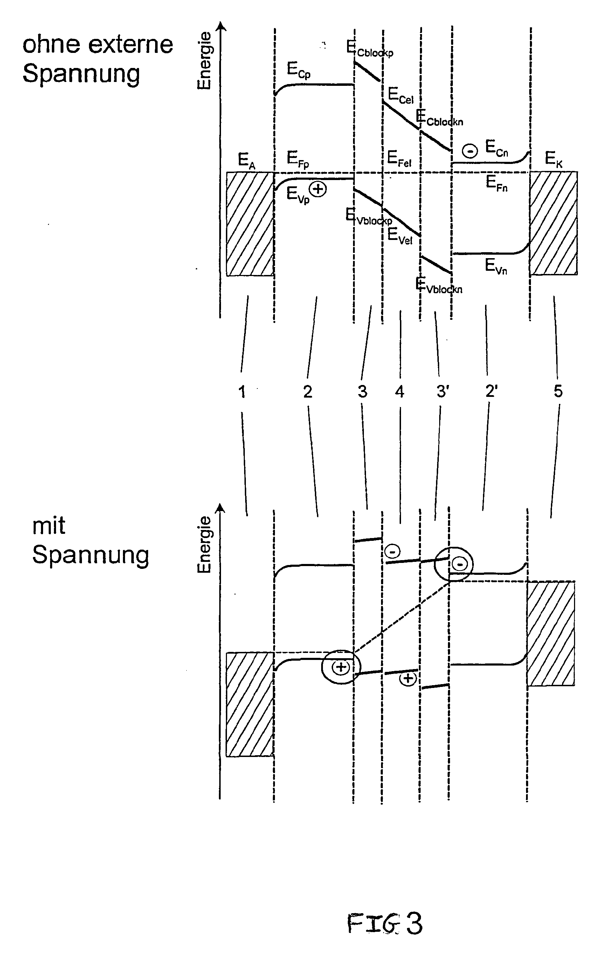

Erfindungsgemäß wird der Nachteil der bisherigen Strukturen durch OLEDs mit dotierten Injektions- und Transportschichten in Verbindung mit Blockschichten vermieden. Fig. 3 zeigt eine entsprechende Anordnung.

Zwischen der löcherinjizierenden und -leitenden Schicht und der lichtemittierenden Schicht befindet sich hierbei eine weitere Schicht, die löcherseitige Blockschicht. Die wichtigsten Bedingungen zur Auswahl dieser Schicht sind: $E_{Vblockp}$ - $E_{Vel}$<0,3eV, damit Löcher an der Grenzfläche löcherleitender Blockschicht / lichtemittierender Schicht nicht geblockt werden. Weiterhin muß gelten: $E_{Cblockp} > E_{Cel}$, damit Elektronen die lichtemittierende Schicht nicht verlassen können. Analog und mit den selben Argumenten muß auf der Elektronenseite gelten: $E_{Cblockn}-E_{Cel} > -0{,}3eV$ und $E_{Vblockn} < E_{Vel}$. Da für reale Materialien eine effiziente Dotierung nur dann möglich ist, falls $E_{Vp} > E_{Vel}$ und $E_{Cn} < E_{Cel}$ gilt, werden also nun Löcher an der Grenzfläche p-dotierter Schicht - löcherseitiger Blockschicht und an der Grenzfläche lichtemittierender Schicht / elektronenseitiger Blockschicht schwach geblockt, Elektronen an den Grenzflächen n-dotierter Schicht zur elektronenseitigen Blockschicht und lichtemittierenden Schicht zur löcherseitigen Blockschicht. Somit sind die Ladungsträger verschiedener Polarität jeweils durch die Dicke der Blockschichten räumlich getrennt. Da diese Trennung bereits über einige Molekülmonolagen sehr effizient Exciplexbildung verhindert, reicht eine sehr geringe Schichtdicke von einigen nm für die Blockschichten aus. Ein weiterer Vorteil dieser Anordnung ist, dass sich in unmittelbarer Nähe der Exzitonen in der lichtemittierenden Schicht keine Dotanden mehr befinden, so daß eine Lumineszenzlöschung durch die Dotanden ausgeschlossen ist.

Diese Anordnung zeichnet sich durch folgende Vorzüge aus:

- eine hohe Ladungsträgerdichte beider Arten in der lichtemittierenden Schicht bereits bei kleinen Spannungen,
- hervorragende Injektion der Ladungsträger von Anode und Kathode in die p- und n-dotierten Ladungsträgertransportschichten,
- hervorragende Leitfähigkeiten in den dotierten Schichten,
- aufgrund ihrer geringen Dicke nur geringe Spannungsverluste in den Blockschichten,
- keine Bildung von Exciplexen, wegen räumlicher Trennung der Ladungsträger unterschiedlicher Polarität, und
- kein Quenching durch Dotanden.

Dies zusammen führt zu hohen Konversionseffizienzen bei niedriger Betriebsspannung für OLEDs mit dieser Schichtstruktur. Dabei können für die lichtemittierende Schicht auch aus der Literatur bekannte Mischschichten eingesetzt werden, welche die Rekombinationseffizienz der Exzitonen steigern, oder die ebenfalls bekannten phosphoreszierenden Materialsysteme mit ihrer höheren Quanteneffizienz.

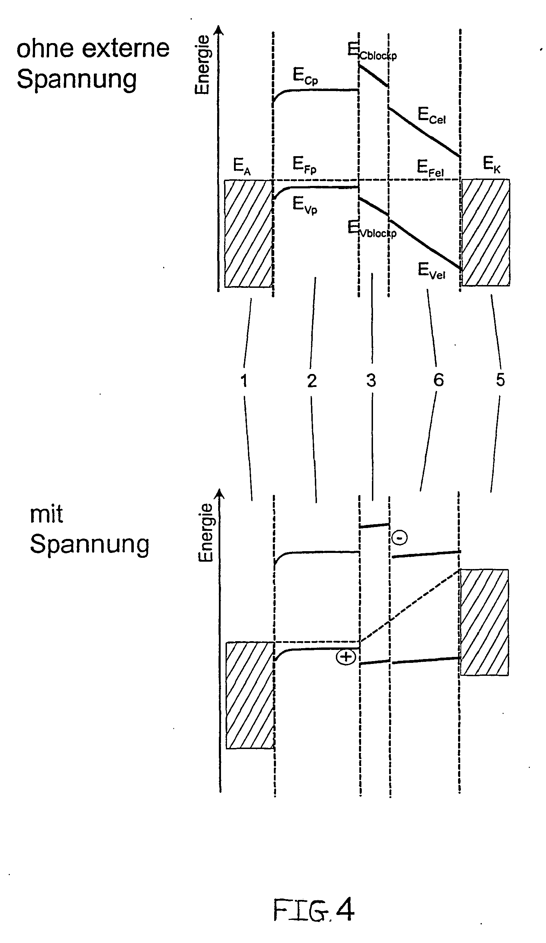

Erfindungsgemäß ist es auch, nur auf einer Seite (Löcher oder Elektronenseite) dotierte Schichten in Kombination mit einer oben beschriebenen Blockschicht (nur einer) zu verwenden (Fig. 4).

Die erfindungsgemäße Schichtfolge führt zwangsläufig zu einer stufenweisen Erhöhung der Transportniveaus $E_A > E_{Vp} > E_{Vblockp}$ auf der Löcherseite bzw. umgekehrt einer stufenweisen Erniedrigung der Transportniveaus $E_K < E_{Cn} < E_{Cblockn}$ auf der Elektronenseite. Die energetischen Verhältnisse in der erfindungsgemäßen Struktur (wie oben dargelegt) werden aus folgenden Gründen so gewählt: Das Problem der Injektionsbarriere vom Kontakt in die Transportschichten wird durch die Bandverbiegung in den dotierten Schichten und damit durch Tunnelinjektion gelöst, so dass die Energieniveaus hierfür weitgehend irrelevant werden. Die Energieniveaus der zu dotierenden Schichten werden aufgrund der begrenzten Stärke der zur Verfügung stehenden Dotanden wie oben beschrieben gewählt, während die Energieniveaus der Blockschichten dazu dienen, die Exciplexbildung zu verhindern.

Als ein bevorzugtes Ausführungsbeispiel soll hier eine Lösung angegeben werden, bei der nur auf der Löcherseite die Kombination aus p-dotierter Injektions- und Transportschicht und Blockschicht eingesetzt wird. Die OLED weist folgende Schichtstruktur auf:

1. Anode: Indium-Zinn-Oxid (ITO)
2. p-dotierte Schicht: 100nm Starburst TDATA 50:1 dotiert mit $F_4$-TCNQ
3. löcherseitige Blockschicht: 10nm Triphenyldiamin (TPD)
4. elektrolumineszierende und (in diesem Fall) herkömmliche elektronenleitende Schicht: 65nm Alq3
5. Kathode: 1nm LiF in Kombination mit Aluminium (LiF verbessert die Injektion am Kontakt).

Die gemischte Schicht (2.) wurde in einem Aufdampfprozeß im Vakuum in Mischverdampfung hergestellt. Prinzipiell können solche Schichten auch durch andere Verfahren hergestellt werden, wie z. B. einem Aufeinanderdampfen der Substanzen mit anschließender möglicherweise temperaturgesteuerter Diffusion der Substanzen ineinander; oder durch anderes Aufbringen (z. B. Aufschleudern) der bereits gemischten Substanzen im oder außerhalb des Vakuums. Die Blockschicht wurde ebenfalls im Vakuum aufgedampft, kann aber auch anders hergestellt werden, z. B. durch Aufschleudern innerhalb oder außerhalb des Vakuums.

Die Energielagen der HOMO und LUMO-Energien betragen:

1. ITO Austrittsarbeit $E_A \approx -4.6eV$ (sehr präparationsabhängig)
2. TDATA: $E_{Vp} = -5.1eV$, $E_{Cp} \approx -2.6eV$
3. TPD: $E_{Vblockp} = -5.4eV$, $E_{Cblockp} = -2.3eV$
4. Alq3: $E_{Vel} = -5.65eV$, $E_{Cel} = -2.9eV$
5. Al: $E_K = -4.3eV$

Bei dieser Anordnung sind die Forderungen $E_{Vblockp} - E_{Vel} < 0{,}3eV$ (0.25eV Differenz) und $E_{Cblockp} > E_{Cel}$ (0.6eV), sowie $E_{Vp} > E_{Vblockp}$ (0.3eV) erfüllt. In dieser bevorzugten Ausführung liegt das LUMO der Löchertransportschicht (TDATA $E_{Cp}$) deutlich höher (0.3eV) als das LUMO der Emitterschicht (Alq$_3$ $E_{Cel}$). Dies ist nicht unbedingt zwingend aber vorteilhaft, um kein Tunneln der Elektronen aus der Emitterschicht in die Löchertransportschicht durch die dünne Blockschicht hindurch zu ermöglichen. Diese OLED weist bei 3.4V eine Lumineszenz von 100cd/m$^2$ auf, mit einer Effizienz von 5cd/A. Mit einer undotierten Schicht TDATA werden 100cd/m$^2$ erst bei ca. 7.5V erzielt. Bei einer OLED wie oben beschrieben, aber ohne TPD-Blockschicht betragen die Kenndaten: 8V für 100cd/m$^2$ und eine um den Faktor 10 schlechtere Effizienz.

Dieses Ausführungsbeispiel zeigt, wie wirkungsvoll die Kombination aus dotierter Transportschicht und Blockschicht hinsichtlich der Optimierung von Betriebsspannung und Lichtemissionseffizienz ist.

Ein weitere erfindungsgemäße Ausführung des Bauelementes besteht darin, dass in die Emitterschicht noch zusätzlich geringere Mengen (0.1-50%) eines Emissionsfarbstoffes gemischt sind (diese Beimischung wird in der Literatur auch als Dotierung - aber keine Dotierung im Sinne der Erfindung - bezeichnet, die Beimischungen daher als Emitterdotanden). Dies können z. B. Quinacridone in Alq$_3$ im oben genannten Ausführungsbeispiel oder Triplet-Emitter wie Ir(ppy)$_3$ (tris(2-phenylpyridine)iridium) in Matrixmaterialien wie TCTA (tris(carbazolyl)-triphenylamine), BCP (Bathocuproine), CBP (dicarbazole-biphenyl) u. ä. sein. Für Triplet-Emitter ist die Konzentration der Emitterdotanden gewöhnlicherweise größer als 1 %. Für diese Materialkombinationen muss durch die Blockschicht die Exciplexbildung zwischen den Blockschichtmaterialien und den Emitterdotanden verhindert werden. Exciplexbildung aus Elektron-Loch-Paaren auf Molekülen des Blockschichtmaterials und des Matrixmaterials kann also möglich sein, so lange wie die Majoritätsladungsträger direkt (also auch ohne Exciplexbildung aus Elektron-Loch-Paaren auf den Blockschichtmolekülen und den Emitterdotandenmolekülen) in Zustände der Emitterdotanden übergehen können, weswegen dann die Exciplexbildung auf Blockschichtmolekülen/Matrixmolekülen verhindert wird. Als energetische Bedingungen für den Anschluss der Blockschichten an die lichtemittierenden Schichten sind daher die Lage der HOMO und LUMO-Niveaus der Emitterdotanden maßgeblich:

a) Bedingung für löcherseitige Blockschicht (3) und emittierende Schicht mit Emitterdotanden (4): $E_{Vblockp} - E_{Veldotand} < 0{,}3eV$ (HOMO Energie der löcherseitigen Blockschicht - HOMO Energie des Emitterdotanden in der lichtemittierenden Schicht < 0.3eV),

b) Bedingung für elektronenseitige Blockschicht (3') und lichtemittierende Schicht mit Emitterdotanden (4): $E_{Cblockn} - E_{Cel} > -0{,}3eV$ (LUMO Energie der elektronenseitigen Blockschicht - LUMO Energie des Emitterdotanden in der lichtemittierenden Schicht > -0.3eV).

**Bezugszeichenliste**

| | |
|---|---|
| $E_A$ | Austrittsarbeit der Anode |
| $E_{Vp}$ | höchstes besetztes molekulares Energieniveau (im Valenzband, HOMO) der Injektions- und Transportschicht für Löcher |
| $E_{Cp}$ | niedrigstes unbesetztes molekulares Energieniveau (Leitungsband bzw. LUMO) der Injektions- und Transportschicht für Löcher |
| $E_{Cpdot}$ | LUMO Energie des p-dotierenden Materials (Akzeptor) |
| $E_{Fp}$ | Ferminiveau der p-dotierten Schicht |
| $E_{Vblockp}$ | HOMO Energie der löcherseitigen Blockschicht |
| $E_{Cblockp}$ | LUMO Energie der löcherseitigen Blockschicht |
| $E_{Fblockp}$ | Ferminiveau der löcherseitigen Blockschicht |
| $E_{Vel}$ | HOMO Energie der lichtemittierenden Schicht |
| $E_{Cel}$ | LUMO Energie der lichtemittierenden Schicht |
| $E_{Fel}$ | Ferminiveau der lichtemittierenden Schicht |
| $E_{Vblockn}$ | HOMO Energie der elektronenseitigen Blockschicht |
| $E_{Cblockn}$ | LUMO Energie der elektronenseitigen Blockschicht |
| $E_{Fblockn}$ | Ferminiveau der elektronenseitigen Blockschicht |
| $E_{Vn}$ | HOMO Energie der Injektions- und Transportschicht für Elektronen |
| $E_{Cn}$ | LUMO Energie der Injektions- und Transportschicht für Elektronen |
| $E_{Vndot}$ | HOMO Energie des n-dotierenden Materials (Donor) |
| $E_{Fn}$ | Ferminiveau der Injektions- und Transportschicht für Elektronen |
| $E_K$ | Austrittsarbeit der Kathode |
| 1 - | Anode |

2 -   Löchertransportschicht
2' -   Elektronentransportschicht
3 -   löcherseitige Blockschicht
3' -   elektronenseitige Blockschicht
4 -   lichtemittierende Schicht
5 -   Katode
6 -   elektronentransportierende und lichtemittierende Schicht

**Patentansprüche**

**1.** Lichtemittierendes Bauelement mit einer Anordnung organischer Schichten, insbesondere organische Leuchtdiode, mit einer löcherinjizierenden Anode (1), einer elektroneninjizierenden Kathode (5) und einer lichtemittierenden Schicht (4), welche ein höchstes besetztes Energieniveau $E_{Vel}$ (HOMO) und ein niedrigstes unbesetztes Energieniveau $E_{Cel}$ (LUMO) aufweist, sowie mindestens einer der folgenden Schichtanordnungen:

(i) eine Löchertransportschicht (2) und eine löcherseitige Blockschicht (3) aus einem organischen Material, welche zwischen der Löchertransportschicht (2) und der lichtemittierenden Schicht (4) angeordnet ist und welche ein höchstes besetztes Energieniveau $E_{Vblockp}$ (HOMO) sowie ein niedrigstes unbesetztes Energieniveau $E_{Cblockp}$ (LUMO) aufweist, wobei die Löchertransportschicht (2) eine organische Hauptsubstanz und eine akzeptorartige Dotierungssubstanz aufweist, wobei $E_{Vp}$ ein höchstes besetztes Energieniveau (HOMO) der Löchertransportschicht (2) und $E_{Cp}$ ein niedrigstes unbesetztes Energieniveau (LUMO) der Löchertransportschicht (2) bezeichnen und wobei für die Energieniveaus gilt:

$$E_{Vblockp} - E_{Vel} < 0{,}3eV$$

$$E_{Cblockp} > E_{Cel},$$

$$E_{Vp} > E_{Vblockp}, \text{ wenn } E_{Vp} > E_{Vel},$$

und

$$E_{Cp} > E_{Cel};$$

und

(ii) eine Elektronentransportschicht (2') und eine elektronenseitige Blockschicht (3') aus einem organischen Material, welche zwischen der Elektronentransportschicht (2') und der lichtemittierenden Schicht (4) angeordnet ist und welche ein höchstes besetztes Energieniveau $E_{Vblockn}$ (HOMO) sowie ein niedrigstes unbesetztes Energieniveau $E_{Cblockn}$ (LUMO) aufweist, wobei die Elektronentransportschicht (2') eine organische Hauptsubstanz und eine donatorartige Dotierungssubstanz aufweist, wobei $E_{Cn}$ ein niedrigstes unbesetztes Energieniveau (LUMO) der Elektronentransportschicht (2') und $E_{Vn}$ ein höchstes besetztes Energieniveau (HOMO) der Elektronentransportschicht (2') bezeichnen und wobei für die Energieniveaus gilt:

$$E_{Cblockn} - E_{Cel} > -0{,}3eV$$

$$E_{Vblockn} < E_{Vel},$$

$$E_{Cn} < E_{Cblockn}, \text{ wenn } E_{Cn} < E_{Cel},$$

und

$$E_{Vn} < E_{Vel},$$

und wobei weiterhin im Bereich der Grenzfläche zwischen der elektronenseitigen Blockschicht (3') und der lichtemittierenden Schicht (4) gilt:

$$E_{Cblockn} \leq E_{Cel}.$$

2. Lichtemittierendes Bauelement nach Anspruch 1, **dadurch gekennzeichnet, daß** die Anode (1) und die Kathode (5) aus Metall sind.

3. Lichtemittierendes Bauelement nach Anspruch 1 oder 2, **dadurch gekennzeichnet, daß** eine Schichtfolge mit der Löchertransportschicht (2), der löcherseitigen Blockschicht (3) und der lichtemittierenden Schicht (4) mehrfach gebildet ist.

4. Bauelement nach einem der vorangehenden Ansprüche, **dadurch gekennzeichnet, daß** die lichtemittierende Schicht (4) aus mehreren Schichten besteht.

5. Bauelement nach einem der vorangehenden Ansprüche, **dadurch gekennzeichnet, daß** zwischen der Anode (1) und der Löchertransportschicht (2) und / oder zwischen der Elektronentransportschicht (2') und der Kathode (5) eine kontaktverbessernde Schicht vorgesehen ist.

6. Bauelement nach einem der vorangehenden Ansprüche, **dadurch gekennzeichnet, daß** die molare Konzentration der Beimischung in der Löchertransportschicht (2) und / oder in der Elektronentransportschicht (2') im Bereich 1: 100 000 bis 5:1 bezogen auf das Verhältnis Dotierungsmoleküle zu Hauptsubstanzmoleküle liegt.

7. Bauelement nach einem der vorangehenden Ansprüche, **dadurch gekennzeichnet, daß** die Schichtdicken der Löchertransportschicht (2) und / oder der Elektronentransportschicht (2') und der Blockschichten (3, 3') im Bereich 0,1 nm bis 50 $\mu$m liegen.

8. Bauelement nach Anspruch 7, **dadurch gekennzeichnet, daß** die Blockschicht (3, 3') jeweils dünner als ihre angrenzende dotierte Transportschicht (2; 2') ist.

**Claims**

1. Light-emitting component comprising an arrangement of organic layers, specifically an organic light-emitting diode, comprising a hole injecting anode (1), an electron injecting cathode (5), and a light-emitting layer (4), said light-emitting layer (4) having a highest occupied energy level $E_{Vel}$ (HOMO), and a lowest unoccupied energy level $E_{Cel}$ (LUMO), further comprising at least one of the following layer arrangements:

(i) a hole-transport layer (2) and a hole-side blocking layer (3) made of an organic material being arranged between said hole-transport layer (2) and said light-emitting layer (4) and having a highest occupied energy level $E_{Vblockp}$ (HOMO) and a lowest unoccupied energy level $E_{Cblockp}$ (LUMO), said hole-transport layer (2) comprising an organic principal substance and an acceptor-like doping substance, wherein $E_{Vp}$ refers to a highest occupied energy level (HOMO) of the hole-transport layer (2) and $E_{Cp}$ refers to a lowest unoccupied energy level (LUMO) of the hole-transport layer (2), and wherein the following holds for the energy levels:

$$E_{Vblockp} - E_{Vel} < 0.3 \text{ eV}$$

$$E_{Cblockp} > E_{Cel},$$

$$E_{Vp} > E_{Vblockp}, \text{ if } E_{Vp} > E_{Vel},$$

and

$$E_{Cp} > E_{Cel};$$

and

(ii) an electron-transport layer (2') and an electron-side blocking layer (3') made of an organic material being arranged between said electron-transport layer (2') and said light-emitting layer (4) and having a highest occupied energy level $E_{Vblockn}$ (HOMO) and a lowest unoccupied energy level $E_{Cblockn}$ (LUMO), said electron-transport layer (2') comprising an organic principal substance and a donor-like doping substance, wherein $E_{Cn}$ refers to a lowest unoccupied energy level (LUMO) of the electron-transport layer (2') and $E_{Vn}$ refers to a highest occupied energy level (HOMO) of the electron-transport layer (2'), and the following holds for the energy levels:

$$E_{Cblockn} - E_{Cel} > -0.3 \text{ eV}$$

$$E_{Vblockn} < E_{Vel},$$

$$E_{Cn} < E_{Cblockn}, \text{ if } E_{Cn} < E_{Cel},$$

and

$$E_{Vn} > E_{Vel},$$

and wherein in the region of the interface between the electron-side blocking layer (3') and the light-emitting layer (4) the following holds:

$$E_{Cblockn} \leq E_{Cel}.$$

2. Light-emitting component according to claim 1, **characterized in that** the anode (1) and cathode (5) are made of metal.

3. Light-emitting component according to claim 1 or 2, **characterized in that** a layer sequence comprising said hole-transport layer (2), said blocking layer (3) and said light-emitting layer (4) is formed repeatedly.

4. Light-emitting component according to one of the previous claims, **characterized in that** the light-emitting layer (4) consists of a plurality of layers.

5. Light-emitting component according to one of the previous claims, **characterized in that** a contact-improving layer is provided between said anode (1) and said hole-transport layer (2) and / or between said electron-transport layer (2') and said cathode (5).

6. Light-emitting component according to one of the previous claims, **characterized in that** the molar concentration of the admixture in the hole-transport layer (2) and / or in the electron-transport layer (2') is in the range of about 1:100,000 to 5:1, relating to the ration doping molecules to principal substance molecules.

7. Light-emitting component according to one of the previous claims, **characterized in that** the layer thickness of said hole-transport layer (2) and / or said electron-transport layer (2') and said blocking layers (3, 3') is in the range of about 0.1nm to 50$\mu$m.

8. Light-emitting component according to claim 7, **characterized in that** each said blocking layer (3, 3') is thinner than its adjacent doped transport layer (2; 2').

**Revendications**

1. Composant électroluminescent pourvu d'un agencement de couches organiques, en particulier une diode électroluminescente organique, ayant des anodes injectant des trous (1), une cathode injectant des électrons (5) et une couche électroluminescente (4), laquelle comprend un niveau d'énergie occupé le plus élevé $E_{Vel}$ (HOMO) et un niveau d'énergie non occupé le plus bas $E_{Cel}$ (LUMO), tout comme au moins un des agencements de couche suivants :

(i) une couche de transport de trous (2) et une couche bloc du côté des trous (3) constituée d'une matière organique, laquelle est agencée entre la couche de transport de trous (2) et la couche électroluminescente (4), et laquelle comprend un niveau d'énergie occupé le plus élevé $E_{Vblockp}$ (HOMO) tout comme un niveau d'énergie non occupé le plus bas $E_{Cblockp}$ (LUMO), la couche de transport de trous (2) comprenant une substance organique principale et un dopant de type accepteur, $E_{Vp}$ désignant un niveau d'énergie occupé le plus élevé (HOMO) de la couche de transport de trous (2) et $E_{Cp}$ désignant un niveau d'énergie non occupé le plus bas (LUMO) de la couche de transport de trous (2) et, pour les niveaux d'énergie, il vaut :

$$E_{Vblockp} - E_{Vel} < 0,3eV$$

$$E_{Cblockp} > E_{Cel},$$

$$E_{Vp} > E_{Vblockp}, \text{ lorsque } E_{Vp} > E_{Vel},$$

et

$$E_{Cp} > E_{Cel};$$

et
(ii) une couche de transport d'électrons (2') et une couche bloc du côté des électrons (3') constituée d'une matière organique, laquelle est agencée entre la couche de transport d'électrons (2') et la couche électroluminescente (4) et comprend un niveau d'énergie occupé le plus élevé $EV_{blockn}$ (HOMO) tout comme un niveau d'énergie non occupé le plus bas $E_{Cblockn}$ (LUMO), la couche de transport d'électrons (2') comprenant une substance principale organique et un dopant de type donateur, $E_{Cn}$ désignant un niveau d'énergie non occupé le plus bas (LUMO) de la couche de transport d'électrons (2') et $E_{Vn}$ désignant un niveau d'énergie occupé le plus élevé (HOMO) de la couche de transport d'électrons (2') et, pour les niveaux d'énergie, il vaut :

$$E_{Cblockn} - E_{Cel} > -0,3eV$$

$$E_{Vblockn} > E_{Vel},$$

$$E_{Cn} > E_{Cblockn} \text{ lorsque } E_{Cn} > E_{Cel}$$

et

$$E_{Vn} > E_{Vel},$$

et, dans le domaine de la surface limite entre la couche bloc du côté des électrons (3') et la couche électroluminescente (4), il vaut :

$$E_{Cblockn} \leq E_{Cel}.$$

2. Composant électroluminescent selon la revendication 1, **caractérisé en ce que** l'anode (1) et la cathode (5) sont en métal.

3. Composant électroluminescent selon la revendication 1 ou 2, **caractérisé en ce qu'**une suite de couches, avec la couche de transport de trous (2), la couche bloc du côté des trous (3) et la couche électroluminescente (4), est formée de manière multiple.

4. Composant électroluminescent selon l'une quelconque des revendications précédentes, **caractérisé en ce que** la couche électroluminescente (4) est constituée de plusieurs couches.

5. Composant électroluminescent selon l'une quelconque des revendications précédentes, **caractérisé en ce qu'**une couche améliorant le contact est prévue entre l'anode (1) et la couche de transport de trous (2) et/ou entre la couche de transport d'électrons (2') et la cathode (5).

6. Composant électroluminescent selon l'une quelconque des revendications précédentes, **caractérisé en ce que** la concentration molaire du mélange dans la couche de transport de trous (2) et/ou dans la couche de transport d'électrons (2') se situe entre 1:100 000 et 5:1 en se basant sur la relation entre molécule dopante et molécule principale.

7. Composant électroluminescent selon l'une quelconque des revendications précédentes, **caractérisé en ce que** les épaisseurs de couche de la couche de transport de trous (2) et/ou de la couche de transport d'électrons (2') et les couches bloc (3, 3') se situent entre 0,1 nm et 50 $\mu$m.

8. Composant électroluminescent selon la revendication 7, **caractérisé en ce que** la couche bloc (3, 3') est respectivement plus fine que sa couche de transport dopée limitrophe (2 ; 2').

ohne externe
Spannung

mit
Spannung

FIG. 1

FIG. 2

FIG 3

16

ohne externe
Spannung

mit
Spannung

FIG.4